# EUROPÄISCHE PATENTSCHRIFT

(11) **EP 1 764 910 B1**
(45) Veröffentlichungstag und Bekanntmachung des Hinweises auf die Patenterteilung: **16.04.2008**
(21) Anmeldenummer: 06018436.3
(22) Anmeldetag: 04.09.2006
(51) Int. Cl.: H03B 11/02

(54) **Mikrowellengenerator**
Microwave generator
Générateur de micro-ondes

(30) Priorität: 16.09.2005 DE 102005044353
(43) Veröffentlichungstag der Anmeldung: 21.03.2007
(73) Patentinhaber: Diehl BGT Defence GmbH & Co.KG, 88662 Überlingen (DE)
(72) Erfinder: Dommer, Josef, 90451 Nürnberg (DE); Staines, Geoffrey, Dr., San Diego 92111 (US)
(74) Vertreter: Diehl Patentabteilung

(56) Entgegenhaltungen:
- EP-A1- 1 473 866
- US-A- 4 104 558

## Beschreibung

Die Erfindung betrifft einen Mikrowellengenerator gemäß dem Oberbegriff des Anspruches 1 mit zwei in einem Gehäuse vorgesehenen Elektroden, die über eine bei Anliegen einer Hochspannung zur Abstrahlung von Mikrowellen durchschlagende Funkenstrecke getrennt sind.

Die Funktion eines solchen Mikrowellengenerators beruht darauf, dass eine Hochspannungsquelle über eine Funkenstrecke kurzgeschlossen und damit entladen wird. Die Hochspannungsquelle kann eine nach dem Prinzip der Marxschen Stoßspannungsschaltung parallel aufgeladene und dann in Serie geschaltete Kondensatorbatterie aufweisen. Alternativ zur Verwendung einer Marxschen Stoßspannungsschaltung kann auch ein explosionsstoffgetriebener Hochspannungsgenerator eingesetzt werden, der im Vergleich mit herkömmlichen Hochspannungsgeneratoren einen einzelnen Hochspannungspuls mit extrem hoher Pulsenergie zur Verfügung stellen kann.

Infolge des Kurzschlusses der Hochspannungsquelle über die Funkenstrecke entstehen stark oszillierende Entlade- bzw. Kurzschlussströme mit steiler Flanke, die eine Mischung sehr hoher Frequenzen erhalten, die über ein eine Antenne bildendes Abstrahlelement als Mikrowellenenergie mit einem breitbandigen, vom Frequenzgemisch abhängigen Spektrum abgestrahlt werden. Dieses breitbandige Mikrowellenspektrum weist eine sehr hohe Energiedichte auf, so dass in der Umgebung eines solchen Mikrowellengenerators beispielsweise der Funkverkehr zumindest beeinträchtigt bzw. Eingangskreise elektronischer Schaltungen aufgrund von Resonanzeffekten gestört oder im Extremfall sogar zerstört werden können.

Aus der DE 101 51 565 A1 ist ein Mikrowellengenerator bekannt, der zwischen axial fluchtend angeordneten Elektroden eine Hochspannungs-Funkenstrecke aufweist, wobei beiderseits der Funkenstrecke die Elektroden und ihre koaxialen Halterungen zumindest über einen Teil ihrer axialen Längenausdehnung von einem distanziert dazu verlaufenden elektrischen Leiter begleitet sind, der an eine der Elektroden elektrisch leitend angeschlossen ist. Bei diesem Mikrowellengenerator ist die Funkenstrecke zwischen einer kleinen pilzkappenförmigen Elektrode und einer größeren keulenartigen Elektrode gebildet. Die keulenartige Elektrode ist von einem äußeren Leiter umgeben, der über eine entsprechende Verbindungsstruktur mit der pilzkappenförmigen Elektrode verbunden ist. Diese Verbindungsstruktur kann gemeinsam mit der pilzkappenförmigen Elektrode über einen Spindelmechanismus in ihrer axialen Position bezüglich der feststehenden zweiten Elektrode und des feststehenden, diese umgreifenden Leiters zum Zwecke der Abstimmung verschoben werden.

Aus der älteren DE-Patentanmeldung 10 2005 002 279 ist ein Mikrowellengenerator mit einer Zentralelektrode, die vorderseitig ein Abstrahlelement aufweist, und mit einer die Zentralelektrode entlang eines sich axial erstreckenden Resonatorabschnittes koaxial umschließenden Außenelektrode bekannt, wobei die beiden Elektroden rotationssymmetrisch ausgebildet sind und eine Funkenstrecke bestimmen, die bei Anliegen einer Hochspannung durchschlägt und über das Abstrahlelement der Zentralelektrode Mikrowellen abstrahlt. Dieser Mikrowellengenerator besteht im wesentlichen aus den beiden metallischen Elektroden, nämlich der Zentralelektrode mit dem Abstrahlelement und der diese koaxial umschließenden Außenelektrode, die den sich axial erstreckenden Resonatorabschnitt des Mikrowellengenerators bestimmen. Die metallischen Elektroden sind an den voneinander abgewandten Enden einer elektrisch isolierenden Gehäusehülse angebracht und können durch einfaches Kontaktieren an den beiden axial voneinander abgewandten Enden der Elektroden mit einer gepulsten Hochspannungsquelle aufgeladen werden. Hierbei handelt es sich um eine sogenannte Zweidrahtspeisung. Im Inneren der Gehäusehülse gibt es außer den beiden Elektroden keine weiteren Bauteile und Komponenten, welche die Hochspannungsfestigkeit beeinträchtigen könnten. Zur Erhöhung der Hochspannungsfestigkeit kann der Innenraum des Mikrowellengenerators mit einem gasförmigen oder flüssigen Dielektrikum gefüllt sein. Bei dem gasförmigen Dielektrikum handelt es sich z.B. um SF₆.

Bei dem Mikrowellengenerator der zuletzt genannten Art ist die Hochspannungsquelle, die vorzugsweise von einem Marx-Generator gebildet ist, seitlich neben dem Mikrowellengenerator und zu diesem parallel angeordnet, so dass die an den voneinander abgewandten Enden des Marx-Generators befindlichen Spannungsausgänge der Hochspannungsquelle an die axial voneinander abgewandten Enden des Mikrowellengenerators angeschlossen werden können. Das gewährleistet eine optimale Spannungsfestigkeit. Die maximale Haltespannung des Mikrowellengenerators wird durch den äußeren Abstand der beiden metallischen Elektroden bestimmt.

Die Funkenstrecke liegt bei diesem bekannten Mikrowellengenerator in seiner Längsachse, d.h. sie ist axial orientiert.

Der Erfindung liegt die Aufgabe zugrunde, einen Mikrowellengenerator der eingangs genannten Art zu schaffen, der anstelle einer seitlich parallelen eine axial lineare Anordnung des Mikrowellengenerators mit einer zugehörigen Hochspannungsquelle ohne Reduktion der Spannungsfestigkeit ermöglicht.

Diese Aufgabe wird erfindungsgemäß durch die Merkmale des Anspruches 1 gelöst. Bevorzugte Aus- bzw. Weiterbildungen des erfindungsgemäßen Mikrowellengenerators sind in den Unteransprüchen gekennzeichnet.

Der erfindungsgemäße Mikrowellengenerator weist den Vorteil auf, dass die Hochspannungsquelle mit dem Mikrowellengenerator axial fluchtend hintereinander anordenbar ist, so dass ein stabförmig zylindrischer Aufbau realisierbar ist und die Resonator-Funkenstrecke in die axial fluchtende Speisung integriert ist.

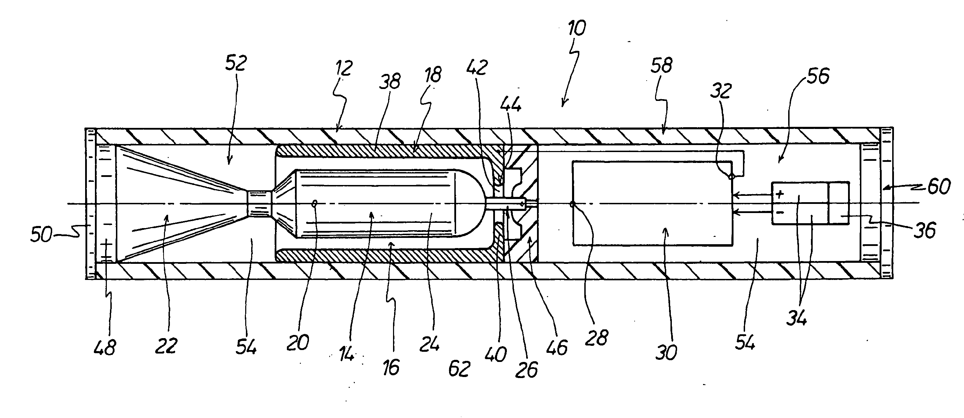

Weitere Einzelheiten, Merkmale und Vorteile ergeben sich aus der nachfolgenden Beschreibung eines in der Zeichnung schematisch in einer Längsschnittdarstellung verdeutlichten Ausführungsbeispieles der erfindungsgemäßen Mikrowellengenerators.

Die Figur zeigt eine Ausbildung des Mikrowellengenerators 10, der in einer Gehäusehülse 12 eine Zentralelektrode 14 und eine die Zentralelektrode 14 entlang eines sich axial erstreckenden Resonatorabschnittes 16 koaxial umschließende Außenelektrode 18 aufweist. Die Zentralelektrode 14 und die Außenelektrode 18 sind um eine zentrale Längsachse 20 herum rotationssymmetrisch ausgebildet.

An die Zentralelektrode 14 schließt vorderseitig materialeinstückig ein Abstrahlelement 22 an, das von der Zentralelektrode 14 weg nach vorne kegelig erweitert ist.

Die Zentralelektrode 14 weist ein den Resonatorabschnitt 16 bestimmendes Keulenteil 24 auf, von dem das Abstrahlelement 22 vorderseitig wegsteht. Rückseitig steht vom Keulenteil 24 ein Anschlusselement 26 mittig, d.h. in Richtung der zentralen Längsachse 20 weg. Das Anschlusselement 26 dient zur Anschlusskontaktierung mit einem Ausgangsanschluss 28 einer Hochspannungsquelle 30. Die Hochspannungsquelle 30 besitzt einen zweiten Ausgangsanschluss 32, der mit der Außenelektrode 18 elektrisch leitenden verbunden ist. Die Hochspannungsquelle 30 ist mit zwei kleinen DCDC-Hochspannungswandlern 34 zusammengeschaltet. Mit der Bezugsziffer 36 ist eine Batterie für die beiden Hochspannungswandler 34 bezeichnet.

Die Hochspannungswandler 34 sind zur Erzeugung einer moderaten Spannung von beispielsweise ± 10 kV vorgesehen. Die Hochspannungsquelle 30 ist zur Erzeugung einer Hochspannung von beispielsweise 300 kV geeignet.

Die Außenelektrode 18 ist topfartig mit einer Zylinderwand 38 und einem rückseitigen Boden 40 ausgebildet, der ein Durchgangsloch 42 aufweist. Das Durchgangsloch 42 ist durch einen Ringrand 44 begrenzt. Durch das Durchgangsloch 42 erstreckt sich das Anschlusselement 26 der Zentralelektrode 14 hindurch.

Das Anschlusselement 26 der Zentralelektrode 14 wird von einem Halteelement 46 zentriert festgehalten. Das Haltelement 46 besteht aus elektrisch isolierendem Material.

Das Anschlusselement 26 mit dem Halteelement 46 dient also zur genau positionierten Festlegung der Zentralelektrode 14 an ihrem rückseitigen Ende. Das Abstrahlelement 22 ist vorderseitig mit einem Abdichtrand 48 ausgebildet, an dem die Gehäusehülse 12 mit ihrem Vorderende eng und dicht anliegt. Das Abstrahlelement 22 ist vorderseitig durch ein Stirnelement 50 verschlossen.

Durch die Gehäusehülse 12, den Abdichtrand 48 des Abstrahleiements 42 und das Halteelement 46 mit dem Anschlusselement 26 ist ein Elektroden-Innenraum 52 bestimmt und abdichtend begrenzt, der mit einem gasförmigen oder flüssigen Dielektrikum 54 gefüllt ist.

Die Gehäusehülse 12 ist über das Halteelement 46 hinaus nach rückwärts verlängert. Die Hochspannungsquelle 30 mit den Hochspannungswandlern 34 und der Batterie 36 sind in dem Raum 56 angeordnet, der durch eine rückseitige Verlängerung 58 der Gehäusehülse 12, das Halteelement 46 und ein rückseitiges abdichtendes Verschlusselement 60 bestimmt ist. Dieser Raum 56 ist vorzugsweise mit dem gleichen gasförmigen oder flüssigen Dielektrikum 54 gefüllt wie der Elektroden-Innenraum 52. In diesem Falle braucht das Halteelement 46 in der Gehäusehülse 12 nicht abdichtend fixiert, sondern nur zur genau zentrierten Positionierung des Anschlusselementes 46 vorgesehen zu sein.

Der erfindungsgemäße Mikrowellengenerator 10 besitzt in vorteilhafter Weise also eine koaxiale Zuführung der gepulsten Hochspannung der Hochspannungsquelle 30, wobei eine unerwünschte Reduktion der Spannungsfestigkeit auf einfache Weise vermieden wird.

Während bei bekannten Mikrowellengeneratoren die zwischen den Elektroden 14 und 18 vorgesehene Funkenstrecke sich in axialer Richtung erstreckt, ist bei dem erfindungsgemäßen Mikrowellengenerator 10 die Funkenstrecke 62 in radialer Richtung ringförmig zwischen dem zentralen Anschlusselement 26 und dem Ringrand 44 des zentralen Durchgangsloches 43 im Boden 40 der Außenelektrode 18 ausgebildet.

### Bezugsziffernliste:

- 10: Mikrowellengenerator
- 12: Gehäusehülse (von 12)
- 14: Zentralelektrode (von 10 in 12)
- 16: Resonatorabschnitt (von 10)
- 18: Außenelektrode (von 10 in 12)
- 20: Zentrale Längsachse (von 10)
- 22: Abstrahlelement (von 10 an 14)
- 24: Keulenteil (von 14)
- 26: Anschlusselement (an 24 für 62)
- 28: Ausgangsanschluss (von 30 für 26)
- 30: Hochspannungsquelle (für 10)
- 32: Zweiter Ausgangsanschluss (von 30 für 18)
- 34: Hochspannungswandler (für 30)
- 36: Batterie (für 34)
- 38: Zylinderwand (von 18)
- 40: Boden (von 18)
- 42: Zentrales Durchgangsloch (in 40)
- 44: Ringrand (von 42)
- 46: Halteelement (für 26 in 12)
- 48: Abdichtrand (von 22)
- 50: Stirnelement (von 22)
- 52: Elektroden-Innenraum (von 10)
- 54: Dielektrikum (in 52 und 56)
- 56: Raum (für 30, 34 und 36)
- 58: Verlängerung (von 12 für 56)
- 60: Verschlusselement (für 56)
- 62: Funkenstrecke (zwischen 26 und 44)

## Patentansprüche

1. Mikrowellengenerator mit einer Zentralelektrode (14), die vorderseitig ein Abstrahlelement (22) aufweist, und mit einer die Zentralelektrode (14) entlang eines sich axial erstreckenden Resonatorabschnittes (16) koaxial umschließenden Außenelektrode (18), wobei die beiden Elektroden (14 und 18) rotationssymmetrisch ausgebildet sind und eine Funkenstrecke (62) bestimmen, die bei Anliegen einer Hochspannung durchschlägt und über das Abstrahlelement (22) der Zentralelektrode (14) Mikrowellen abstrahlt,
**dadurch gekennzeichnet,**
**dass** die Funkenstrecke (62) als Ringfunkenstrecke ausgebildet ist, die durch ein von der Zentralelektrode (14) rückseitig axial mittig wegstehendes Anschlusselement (26) und einen zum Anschlusselement (26) koaxial vorgesehenen Ringrand (44) der Außenelektrode (18) bestimmt ist.

2. Mikrowellengenerator nach Anspruch 1,
**dadurch gekennzeichnet,**
**dass** die Zentralelektrode (14) ein den Resonatorabschnitt (16) bestimmendes Keulenteil (24) aufweist, von dem vorderseitig das Abstrahlelement (22) und rückseitig das Anschlusselement (26) wegsteht.

3. Mikrowellengenerator nach Anspruch 1 oder 2,
**dadurch gekennzeichnet,**
**dass** die Außenelektrode (18) topfartig mit einer Zylinderwand (38) und einem Boden (40) ausgebildet ist, wobei der Boden (40) ein zentrales Durchgangsloch (42) aufweist, durch dessen Ringrand (44) die Funkenstrecke (62) begrenzt ist und durch das sich das Anschlusselement (26) der Zentralelektrode (14) hindurcherstreckt.

4. Mikrowellengenerator nach einem der Ansprüche 1 bis 3,
**dadurch gekennzeichnet,**
**dass** die Zentralelektrode (14) und die Außenelektrode (18) in einer Gehäusehülse (12) aus elektrisch isolierendem Material angeordnet sind, wobei das Abstrahlelement (22) mit einem vorderseitigen Abdichtrandabschnitt (48) gegen die Gehäusehülse (12) abgedichtet ist.

5. Mikrowellengenerator nach Anspruch 4,
**dadurch gekennzeichnet,**
**dass** das Anschlusselement (26) der Zentralelektrode (14) von einem Halteelement (46) aus elektrisch isolierendem Material zentriert gehalten wird, das in der Gehäusehülse (12) vorgesehen ist.

6. Mikrowellengenerator nach Anspruch 5,
**dadurch gekennzeichnet,**
**dass** das Halteelement (46) am rückseitigen Ende der Gehäusehülse (12) abdichtend vorgesehen ist.

7. Mikrowellengenerator nach Anspruch 6,
**dadurch gekennzeichnet,**
**dass** der durch die Gehäusehülse (12), den Abdichtrandabschnitt (48) des Abstrahlelementes (22) und das Halteelement (46) begrenzte Elektroden-Innenraum (52) mit einem gasförmigen oder einem flüssigen Dielektrikum gefüllt ist.

8. Mikrowellengenerator nach Anspruch 4 oder 5,
**dadurch gekennzeichnet,**
**dass** die Gehäusehülse (12) über das Halteelement (46) hinaus axial verlängert ist, und dass in dem durch die Verlängerung (58) der Gehäusehülse (12) bestimmten, rückseitig dicht verschlossenen Raum (56) eine Hochspannungsquelle (30) vorgesehen ist.

9. Mikrowellengenerator nach Anspruch 8,
**dadurch gekennzeichnet,**
**dass** der Raum (56), in dem die Hochspannungsquelle (30) vorgesehen ist, mit einem gasförmigen oder flüssigen Dielektrikum (54) gefüllt ist.

10. Mikrowellengenerator nach Anspruch 7 und 9,
**dadurch gekennzeichnet,**
**dass** der Elektroden-Innenraum (52) und der Raum (56), in dem die Hochspannungsquelle (30) angeordnet ist, mit dem gleichen gasförmigen oder flüssigen Dielektrikum (54) gefüllt sind.

11. Mikrowellengenerator nach einem der Ansprüche 8 bis 10,
**dadurch gekennzeichnet,**
**dass** in dem durch die Gehäusehülsen-Verlängerung (58) bestimmten Raum (56) eine Energieversorgung (34, 36) für die Hochspannungsquelle (30) vorgesehen ist.

## Claims

1. Microwave generator having a central electrode (14) which has an emission element (22) on the front face, and having an outer electrode (18), which surrounds the central electrode (14) coaxially along an axially extending resonator section (16), with the two electrodes (14 and 18) being rotationally symmetrical and defining a spark gap (62) which breaks down when a high voltage is applied and emits microwaves via the emission element (22) of the central electrode (14),
**characterized in that**
the spark gap (62) is an annular spark gap which is defined by a connecting element (26), which projects axially and centrally on the rear face from the central electrode (14), and an annular rim (44), which is provided coaxially with respect to the connecting element (26), on the outer electrode (18).

2. Microwave generator according to Claim 1,
**characterized in that**
the central electrode (14) has a lobe part (24) which defines the resonator section (16) and from which the emission element (22) projects away on the front face and the connecting element (26) projects away on the rear face.

3. Microwave generator according to Claim 1 or 2,
**characterized in that**
the outer electrode (18) is in the form of a pot with a cylindrical wall (38) and a base (40), with the base (40) having a central aperture hole (42) whose annular rim (44) bounds the spark gap (62), and through which the connecting element (26) of the central electrode (14) extends.

4. Microwave generator according to one of Claims 1 to 3,
**characterized in that**
the central electrode (14) and the outer electrode (18) are arranged in a housing sleeve (12) composed of electrically insulating material, with the emission element (22) being sealed with respect to the housing sleeve (12) by a sealing rim section (48) on the front face.

5. Microwave generator according to Claim 4,
**characterized in that**
the connecting element (26) of the central electrode (14) is held centred by a holding element (46) which is composed of electrically insulating material and is provided in the housing sleeve (12).

6. Microwave generator according to Claim 5,
**characterized in that**
the holding element (46) is provided, forming a seal, at the rear-face end of the housing sleeve (12).

7. Microwave generator according to Claim 6,
**characterized in that**
the electrode internal area (52) which is bounded by the housing sleeve (12), the sealing rim section (48) of the emission element (22) and the holding element (46) is filled with a gaseous or a liquid dielectric.

8. Microwave generator according to Claim 4 or 5,
**characterized in that**
the housing sleeve (12) is lengthened axially beyond the holding element (46), and **in that** a high-voltage source (30) is provided in the area (56) which is defined by the extension (58) of the housing sleeve (12) and is sealed on the rear face.

9. Microwave generator according to Claim 8,
**characterized in that**
the area (56) in which the high-voltage source (30) is provided is filled with a gaseous or liquid dielectric (54).

10. Microwave generator according to Claims 7 and 9,
**characterized in that**
the electrode internal area (52) and the area (56) in which the high-voltage source (30) is arranged are filled with the same gaseous or liquid dielectric (54).

11. Microwave generator according to one of Claims 8 to 10,
**characterized in that**
a power supply (34, 36) for the high-voltage source (30) is provided in the area (56) which is defined by the housing sleeve extension (58).

## Revendications

1. Générateur d'hyperfréquence comprenant une électrode centrale (14) qui présente à l'avant un élément rayonnant (22) et comprenant une électrode extérieure (18) qui entoure l'électrode centrale (14) de manière coaxiale le long d'une section de résonateur (16) qui s'étend dans le sens axial, les deux électrodes (14 et 18) étant configurées avec une symétrie rotationnelle et déterminant une distance de décharge (62) qui est traversée lors de l'application d'une haute tension et qui émet des hyperfréquences par le biais de l'élément rayonnant (22) de l'électrode centrale (14), **caractérisé en ce que** la distance de décharge (62) est réalisée sous la forme d'une distance de décharge annulaire qui est déterminée par un élément de raccordement (26) à l'écart de l'électrode centrale (14) du côté arrière au centre dans le sens axial et par un bord annulaire (44) prévu de l'électrode extérieure (18) de manière coaxiale par rapport à l'élément de raccordement (26).

2. Générateur d'hyperfréquence selon la revendication 1, **caractérisé en ce que** l'électrode centrale (14) présente une partie en lobe (24) qui définit la section de résonateur (16) et de laquelle s'écartent l'élément rayonnant (22) par l'avant et l'élément de raccordement (26) par l'arrière.

3. Générateur d'hyperfréquence selon la revendication 1 ou 2, **caractérisé en ce que** l'électrode extérieure (18) est réalisée en forme de pot avec une paroi cylindrique (38) et un fond (40), le fond (40) présentant un trou de passage central (42) dont le bord annulaire (44) délimite la distance de décharge (62) et à travers lequel s'étend l'élément de raccordement (26) de l'électrode centrale (14).

4. Générateur d'hyperfréquence selon l'une des revendications 1 à 3, **caractérisé en ce que** l'électrode centrale (14) et l'électrode extérieure (18) sont disposées dans un manchon de boîtier (12) en matériau électriquement isolant, l'élément rayonnant (22) étant rendu étanche par rapport au manchon de boîtier (12) avec une section de bord d'étanchéité avant (48).

5. Générateur d'hyperfréquence selon la revendication 4, **caractérisé en ce que** l'élément de raccordement (26) de l'électrode centrale (14) est maintenu centré par un élément de maintien (46) en matériau électriquement isolant qui est prévu dans le manchon de boîtier (12).

6. Générateur d'hyperfréquence selon la revendication 5, **caractérisé en ce que** l'élément de maintien (46) est prévu en réalisant l'étanchéité à l'extrémité arrière du manchon de boîtier (12).

7. Générateur d'hyperfréquence selon la revendication 6, **caractérisé en ce que** l'espace intérieur d'électrode (52), délimité par le manchon de boîtier (12), la section de bord d'étanchéité (48) de l'élément rayonnant (22) et l'élément de maintien (46), est rempli d'un diélectrique gazeux ou liquide.

8. Générateur d'hyperfréquence selon la revendication 4 ou 5, **caractérisé en ce que** le manchon de boîtier (12) est prolongé dans le sens axial par l'élément de maintien (46) et qu'une source de haute tension (30) est prévue dans l'espace (56) fermé hermétiquement à l'arrière et produit par la prolongation (58) du manchon de boîtier (12).

9. Générateur d'hyperfréquence selon la revendication 8, **caractérisé en ce que** l'espace (56) dans lequel est prévue la source de haute tension (30) est rempli d'un diélectrique gazeux ou liquide.

10. Générateur d'hyperfréquence selon les revendications 7 et 9, **caractérisé en ce que** l'espace intérieur d'électrode (52) et l'espace (56) dans lequel est disposée la source de haute tension (30) sont remplis du même diélectrique (54) gazeux ou liquide.

11. Générateur d'hyperfréquence selon l'une des revendications 8 à 10, **caractérisé en ce qu'**une source d'énergie (34, 36) pour la source de haute tension (30) est prévue dans l'espace (56) déterminé par la prolongation du manchon de boîtier (58).
